Europäisches Patentamt

European Patent Office

Office européen des brevets

(11) Publication number: **0 081 966**
**B1**

(12) EUROPEAN PATENT SPECIFICATION

(45) Date of publication of patent specification: **04.11.87**

(21) Application number: **82306522.2**

(22) Date of filing: **07.12.82**

(51) Int. Cl.⁴: **G 06 F 11/26, G 06 F 11/30,**
**G 06 F 12/00**

(54) Scan-out circuitry.

(30) Priority: **09.12.81 JP 196746/81**

(43) Date of publication of application:
**22.06.83 Bulletin 83/25**

(45) Publication of the grant of the patent:
**04.11.87 Bulletin 87/45**

(84) Designated Contracting States:
**DE FR GB**

(56) References cited:
**WO-A-79/00035**
**DE-A-2 952 631**

**IBM TECHNICAL DISCLOSURE BULLETIN,**
**Vol.18, No.10, March 1976, New York (US)**
**pages 3329-3330; D.ESTEBAN: "Shift register**
**implemented by indexing a random-access**
**memory"**

(73) Proprietor: **FUJITSU LIMITED**
**1015, Kamikodanaka Nakahara-ku**
**Kawasaki-shi Kanagawa 211 (JP)**

(72) Inventor: **Ozawa, Hidekiyo**
**1-13-7, Miyazaki, Miyamae-ku Kawasaki-shi**
**Kanagawa**
**Miyazakidai Green Heights 309, 213 (JP)**
Inventor: **Itoh, Mikio 974-1, Shinohara-cho**
**Kohoku-ku Yokohama-shi Kanagawa**
**Shinohara Corporas A-306, 222 (JP)**
Inventor: **Yoshida Akira 1-23-10, Saginuma**
**Miyamae-ku Kawasaki-shi Kanagawa**
**Saginuma Koen Sky Mansion 210, 213 (JP)**

(74) Representative: **Sunderland, James Harry et al**
**HASELTINE LAKE & CO Hazlitt House 28**
**Southampton Buildings Chancery Lane**
**London WC2A 1AT (GB)**

Courier Press, Leamington Spa, England.

# Description

The present invention relates to scan-out circuitry which permits scanning out of a shift register formed by a memory or register file.

The scan-out method can be of wide application for detecting the internal state of circuitry.

For example, the LSI fabrication of a circuit can cause problems in that it is difficult to detect directly the state of the circuit because the number of input/output pins is limited. The scan-out method can provide an effective means for directly detecting the internal state of a circuit using the limited number of input/output pins. Attention is directed to DE—A—2 952 631.

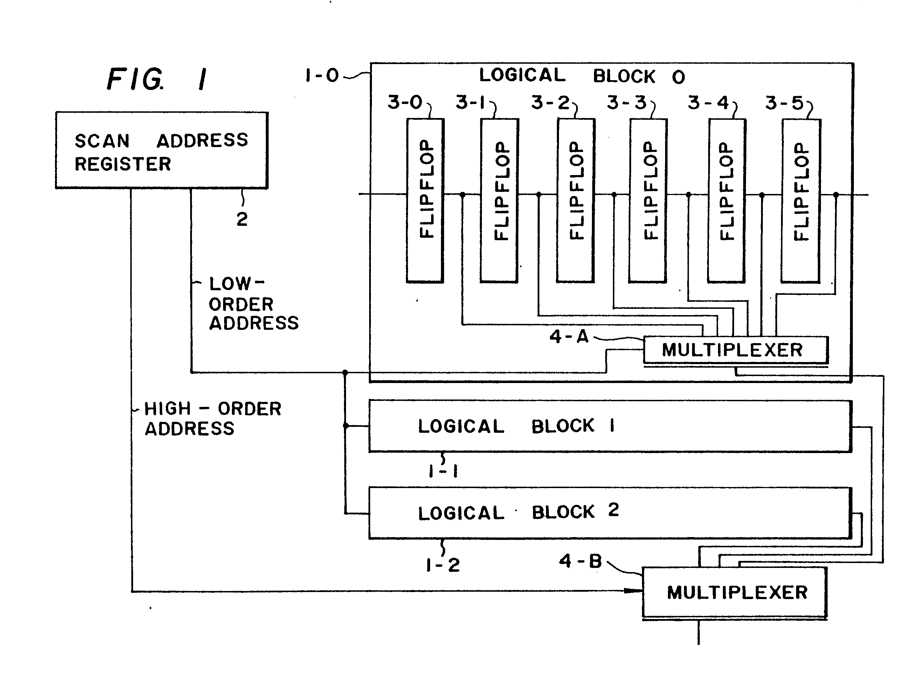

Fig. 1 of the accompanying drawings is a schematic block diagram for explaining in outline a scan out system.

In Fig. 1, 1-0 to 1-2 are logical blocks; 2 is a scan address register; 3-0 to 3-5 are flip-flops; 4-A and 4-B are multiplexers. To the flip-flops and to gates forming the circuit addresses are respectively assigned, which addresses are called scan addresses. The scan addresses are each set in the scan address register 2. The low-order part of each address represents a scan address within a logical block whilst the high-order part identifies the logical block concerned. In the illustrated example, the low-order part address of a scan address is delivered to the multiplexer 4-A of each logical block 1-0 to 1-2 in common and, by means of the multiplexer 4-A of each block, the status of one flip-flop in each logical block 1-0 to 1-2 is read out. All the statuses are read out in parallel with one another. Data read out from the logical blocks 1-0, 1-1 and 1-2 is input to the multiplexer 4-B. The high-order part address in the scan address register 2 is applied to the multiplexer 4-B and, in accordance with this high-order address, the multiplexer 4-B selects and outputs one data item (one status) input thereto. The output of the multiplexer 4-B is provided, for instance, to a service processor. To take out the status of a desired flip-flop or gate in an apparatus to the outside is called "scan out".

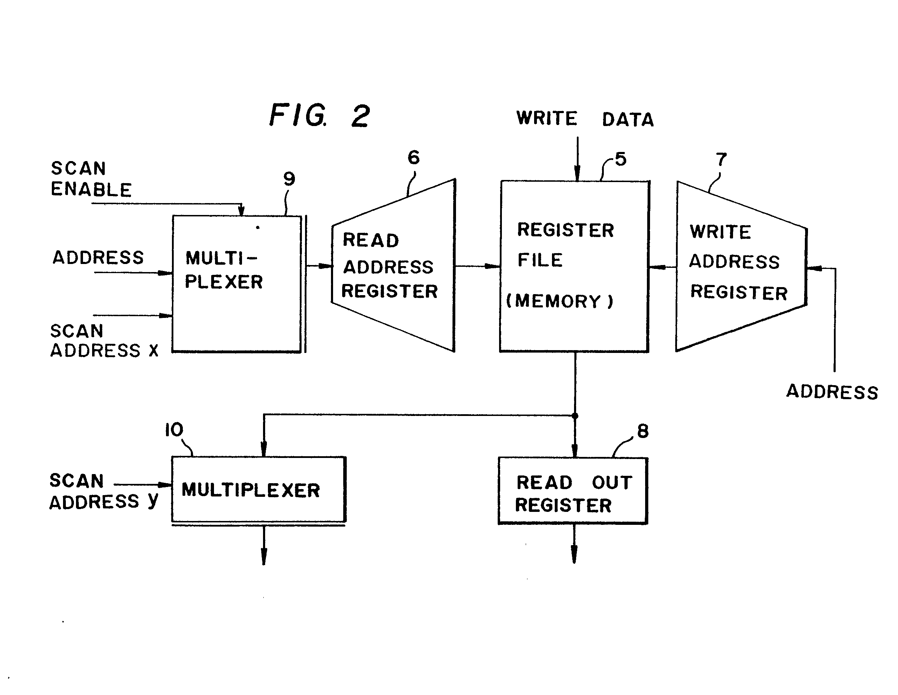

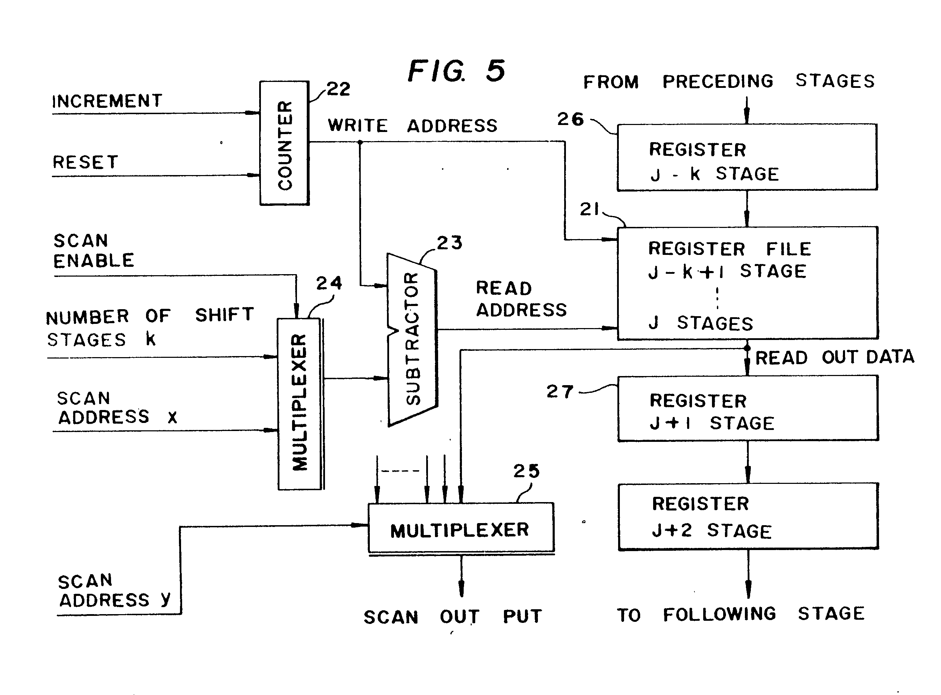

Since a part formed by a memory element, such as a register file, calls for a memory readout operation, it cannot be subjected to scan-out if held as it is. However, even a memory can be scanned out through utilization of an arrangement as shown in Fig. 2 of the accompanying drawings, which is a schematic block diagram. In Fig. 2, 5 is a register file (a memory); 6 is a read address register; 7 is a write address register; 8 is a readout register; 9 is a multiplexer; and 10 is a multiplexer. In Fig. 2 the multiplexer 9 is provided in a memory address input part. To the multiplexer 9 are input an address from a logical circuit for inputting and outputting data to the register file 5 and a scan address x (corresponding to the aforementioned low-order part address) from a service processor or the like. When a scan enable signal is OFF, the multiplexer 9 is used for providing a readout address. Usually, while the system is in operation, a memory address is supplied from the logical circuit for inputting and outputting data to the register file 5 but, while the system is out of operation, a scan address in provided from the service processor or the like and the content of an address location identified by the scan address is output as readout data. At this time, since the system is not in operation, data read out from the memory 5 is not set in the readout register 8. What is meant by "when the system is not in operation" is a period when the system is in a check-stop state and clock is stopped, or in a manual clock state and no clock is supplied. During scan-out, data read out from the memory 5 is input to the multiplexer 10. To the multiplexer 10 read-out data from other circuit blocks (not shown) is also input, and the multiplexer 10 follows a scan address y (corresponding to a high order part address) input thereto as control information to select and output one item of input data.

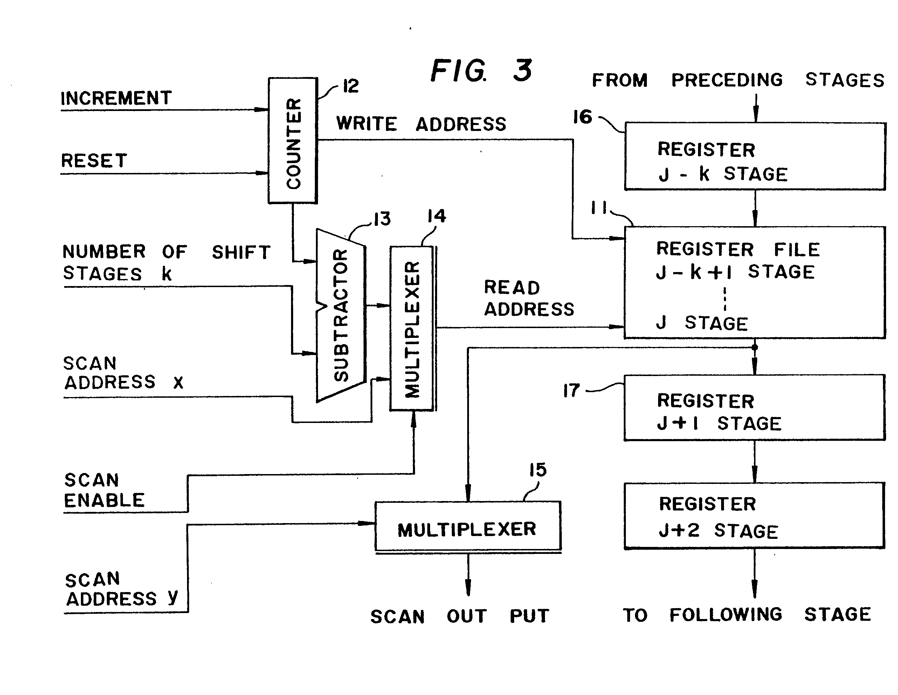

Fig. 3 of the accompanying drawings is a schematic block diagram which illustrates a shift register formed by a register file. In this regard attention is directed to IBM Technical Disclosure Bulletin, Vol. 18, No. 10, March 1976, pages 3329—3330. In Fig. 3, 11 is a register file; 12 is a counter; 13 is a subtractor; 14 and 15 are multiplexers; 16 is a preceding-stage register; and 17 is a following-stage register. The register file is one that is capable of concurrent execution of both write and read operations in the same cycle. The counter 12 is used to designate a write address for the register file 11 and the subtractor 13 subtracts an arbitrary number k from the value of the counter 12 to produce a read address. By such an arrangement, a shift register can be constituted. Since such an arrangement permits the constitution of shift registers of a desired number of stages, using the same basic circuit arrangement, it is often employed as a control shift register for a pipeline or the like.

Now, a description will be given of a case in which shift registers of five stages are formed by the register file 11, having eight registers, in Fig. 3. When the value of the counter 12 is "5", the write address of the register file 11 indicates a register of an address 5, but the read address indicates a register of an address 0 as a result of operation of the subtractor 13. By shift operation, the content of the register of the address 0 is ready out at the same time as data is written in the shift register of the address 5 and, thereafter, the value of the counter 12 is incremented by one and the write address indicates a register of an address 6 and the read address a register of an address 1. When the shift operation has been carried out five times by sequentially repeating the abovesaid operations, the read address indicates a fifth address and the content of the register of the address 5 is ready out after the shift operation has been effected five times. The values of the other registers are respectively read out after the shift operation has taken place five times. In this way, there are effectively constituted shift registers of stages equal in number to the constant (e.g. 5) provided to the input of the subtractor.

For scanning out the content of such a register file 11, the multiplexer 14 is provided in the read address input part of the register file 11 as is the case with Fig. 2, by which the output of the subtractor 13 is normally selected as the read address whilst a scan address X (low-order part address) is selected as the read address during the scan-out. By the way, the multiplexer 15 is controlled by the scan address y (high-order part address).

Such a scan-out method as is described above with respect to Fig. 2 is very convenient when the memory read addresses and the scan addresses have one-to-one correspondence but, with regard to such a shift register formed by a register file arrangement as shown in Fig. 3, the following point should be taken into account.

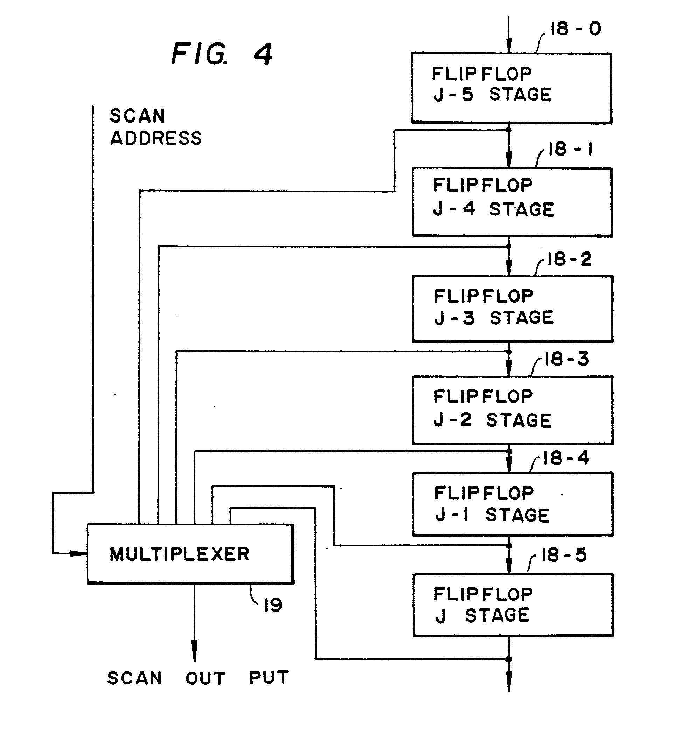

Fig. 4 of the accompanying drawings is a schematic block diagram explanatory of the scan-out of an ordinary shift register. 18-0 to 18-5 are flip-flops; and 19 is a multiplexer. In a case in which the shift register is formed by serial connection of the flip-flops 18-0 to 18-5 as shown in Fig. 4, scanning of (j-5)th to jth stages of the shift register can be performed using scan addresses applied to the flip-flops 18-0 to 18-5. For example, when the (j-5)th stage of the shift register is to be scanned, the flip-flop 18-0 iks scanned and when the jth stage of the shift register is to be scanned, the flip-flop 18-5 is scanned.

Where a shift register is constituted by the register file as shown in Fig. 3, however, the positions of the stages of the shift register do not have an absolute one-to-one correspondence to the numbers of the registers in the register file but rather have a relative correspondence relationship dependent upon the value of the counter. For instance, when data is written in the fifth register and data is read out from the 0th register, the jth stage of the shift register is the 0th register and the (j-5)th stage corresponds to the fifth register. When the next shift operation takes place, the fifth register becomes the (j-4)th stage; namely, the correspondence differs from that in the immediately preceding shift cycle. In this way, the correspondence between the stages of the shift register and the numbers of the registers changes constantly, so that to scan a desired number of stages of the shift register it is customary in the prior art to determine the numbers of the registers, noting the value of the counter which determines the write address of the register file. However, this is inconvenient because the scan address is, in effect, floating.

According to the present invention there is provided scan-out circuitry for a shift register formed by a memory, a counter for providing a count value for designating a write address of the memory and an operator for effectively subtracting a constant value related to the number of shift stages of the shift register from the count value of the counter for designating a read address of the memory, characterised in that the circuitry includes a multiplexer, provided at the input side of the operator, arranged for receiving the constant value and a scan-out address, and operable to deliver either the said constant value or the scan-out address to the operator, in accordance with a scan enable signal supplied to the multiplexer, the scan-out address being delivered to the operator to determine the status of a stage of the shift register in a scan-out operation.

An embodiment of the present invention can provide scan-out circuitry by which data in a desired stage of a k-stage shift register, which shift register comprises a memory, a counter for specifying a write address of the memory and a subtractor for subtracting an arbitrary value k from the value of the counter to specify a read address, can be scanned out without the necessity for preknowledge of the value of the counter.

An embodiment of the present invention need have only a simple circuit arrangement.

Briefly, in scan-out circuitry embodying the present invention, for use with a shift register comprising a memory, a counter for specifying a write address of the memory and an operator for subtracting an arbitrary value from the count value of the counter to specify a read address of the memory, a multiplexer is provided at the input side of the operator for calculating the read address of the memory. Either (a) a constant for determining the number of shift stages or (b) a scan address, which are both input to the multiplexer, is selected in accordance with a scan enable signal which is also input to the multiplexer and data selectively output from the multiplexer is input to the input terminal of the operator.

Reference is made, by way of example, to the accompanying drawings, in which:

Fig. 1 is a schematic block diagram for assistance in explaining in outline a scan-out system;

Fig. 2 is a schematic block diagram illustrating an arrangement for applying a scan-out system to a memory or register file;

Fig. 3 is a schematic block diagram illustrating a conventional arrangement for applying a scan-out system to a shift register formed by a register file;

Fig. 4 is a schematic block diagram illustrating the application of a scan-out system to a shift register formed by a series connection of flip-flops; and

Fig. 5 is a schematic block diagram illustrating an embodiment of the present invention applied to a shift register formed by a register file.

In Fig. 5, 21 is a register file; 22 is a counter; 23 is a subtractor; 24 is a multiplexer; 25 is a multiplexer; 26 is a register for holding input data to the register file 21; and 27 is a register for holding output data from the register file 21.

The register file 21 comprises a plurality of registers. The counter 22 is one that represents a write address to be supplied to the register file 21 and is capable of counting from 0 to $2^n-1$, for instance. The register file 21 has addresses 0 to $2^n-1$. The subtractor 23 is for subtracting a value provided by multiplexer 24 from the count value of the counter 22. Let it be assumed that numerical values are each represented by three bits in the following way. When the count value of the counter 22 is "2" and the output of the multiplexer 24 is "3", a substraction of the latter from the former gives "−1" but, when the numerical values are represented by three bits in this embodiment, the subtractor 23 outputs a numerical value "6". The output of the subtractor 23 is used as a read address. To the multiplexer 24 there is applied data indicating the number of shift stages k of a shift register being formed using the register file 21 and data indicating a scan address x, and a scan enable signal is applied as control information to the multiplexer 24. The multiplexer 24 outputs the number of shift stages k or the scan address x depending on whether the scan enable stage signal is OFF or ON. The multiplexer 25 is supplied, during scan-out, with data read out from the register file 21 and data read out from other circuit blocks. The multiplexer 25 selects and outputs one of the plurality of input data items in accordance with a scan address y.

This embodiment of the present invention usually operates as follows: let it be assumed that the number of shift stages is "5", and that the count value of the counter 22 is also "5". In this case, data is written in a fifth register of the register file 21 and data is read out from a zeroth register; the jth to (j-5)th stages of the shift register in Fig. 4 correspond to zeroth to fifth registers in Fig. 5, respectively.

During the scan-out the multiplexer 24 inputs to the subtractor 23 the scan address x in place of the number of shift stages k. When scanning the jth stage when the value of the counter 22 is "5", the zeroth register is to be read out. Accordingly, since the value of the counter 22 indicates "5", the scan address x must be "5". To scan the (j-1)th to (j-5)th stages, the scan address x takes the values of "4", "3", "2", "1" and "0", respectively.

Thus, in Fig. 5, by making the scan address x supplied to the multiplexer 24 take values "5" to "0" in sequence, and by supplying the scan address from the multiplexer to the subtractor, the shift register stages are scanned in proper order.

When a shift operation is subsequently carried out, the value of the counter 22 becomes "6" and the read address becomes "1". At this time, the jth to (j-5)th stages correspond to the first to sixth registers of the register file 21, respectively.

When performing scan-out in this state, the content of the first register of the register file 21 is scanned out when the scan address x is "5", because the counter 22 indicates "6" and the read address provided by the subtractor is "1". In this case, of course, the first register corresponds to the jth stage of the shift register. Similarly, when the scan address x is "4", data from the second register is scanned out. In a similar manner, as the scan address changes to "3", "2", "1" and "0" in a sequential order, data from the third, fourth, fifth and sixth registers are scanned out. When the value of the counter 21 is "6", of course, the third, fourth, fifth and sixth registers respectively correspond to the (j-2)th, (j-3)th, (j-4)th and (j-5)th stages. Thus, by supplying the sequence of scan address values to the subtractor the shift register stages are again scanned in proper order, after shift operation.

As will be understood from the above, in the present invention, since the scan address (x) is modified by the value of the counter (in the subtractor), a desired one of the stages of the shift register can be scanned out in any shift condition without the necessity of learning the value of the counter.

Whilst in the embodiment of Fig. 5 a subtractor is used for modifying the read address of the register file, an adder can be employed in place of the subtractor with a complement of the number of stages of the register file input thereto as a modification constant (in place of the number of stages k). The scan addresses (x) may then be supplied as complements in relation to the addresses supplied in Fig. 5.

Thus, the present invention provides a scan-out system for a shift register formed by a memory, a counter for designating a write address of the memory and an operator for subtracting a constant value related to the number of shift stages of the shift register from the count value of the counter to designate a read address of the memory, the improvement comprising a multiplexer provided at the input side of the operator, for calculating the read address of the memory, wherein either one of a constant for determining the number of shift stages of the shift register and a scan address, which are both input to the multiplexer, is selected in accordance with a scan enable signal input to the multiplexer and data selectively output from the multiplexer is input to the input terminal of the operator.

In the scan-out system the operator can be a subtractor for subtracting the constant from the count value of the counter.

Alternatively, the operator can be an adder for adding a complement of the constant to the count value of the counter.

**Claims**

1. Scan-out circuitry for a shift register formed by a memory (21), a counter (22) for providing a count value for designating a write address of the memory and an operator (23) for effectively subtracting a constant value related to the number of shift stages of the shift register from the count value of the counter for designating a read address of the memory, characterised in that the circuitry includes a multiplexer, provided at the input side of the operator, arranged for receiving the constant value and a scan-out address, and operable to deliver either the said constant value or the scan-out address to the operator, in accordance with a scan enable signal supplied to the multiplexer, the scan-out address being delivered to the operator to determine the status of a stage of the shift register in a scan-out operation.

2. Scan-out circuitry as claimed in claim 1, in combination with the shift register, wherein the operator is a subtractor for subtracting the constant value from the count value of the counter.

3. Scan-out circuitry as claimed in claim 1, in combination with the shift register, wherein the operator is an adder for adding a complement of the constant value to the count value of the counter.

## Patentansprüche

1. Ausleseschaltung für ein Schieberegister, das gebildet ist aus einem Speicher (21), einem Zähler (22), der einen Zählwert zur Bestimmung einer Schreibadresse des Speichers liefert, und einem Operator (23), um effektiv einen konstanten Wert, der die Zahl der Schiebestufen des Schieberegisters betrifft, von dem Zählwert des Zählers zu subtrahieren, um eine Leseadresse des Speichers zu bestimmen, dadurch gekennzeichnet, daß die Schaltung einen Multiplexer umfaßt, der an der Eingangsseite des Operators vorgesehen und angeordnet ist, um den konstanten Wert und eine Ausleseadresse zu empfangen, und betreibbar ist, um entweder den genannten Konstantenwert oder die Ausleseadresse an den Operator zu liefern, in Übereinstimmung mit einem Auslesefreigabesignal, welches dem Multiplexer zugeführt wird, wobei die Ausleseadresse an den Operator geliefert wird, um den Status einer Stufe des Schieberegisters beim Auslesebetrieb zu bestimmen.

2. Ausleseschaltung nach Anspruch 1, in Kombination mit dem Schieberegister, bei welcher der Operator ein Subtraktor ist, um den konstanten Wert von dem Zählwert des Zählers abzuziehen.

3. Ausleseschalter nach Anspruch 1, in Kombination mit einem Schieberegister, bei dem der Operator ein Addierer ist, um ein Komplement des konstanten Wertes zu dem Zählwert des Zählers zu addieren.

## Revendications

1. Circuit de balayage en sortie destiné à un registre à décalage formé par une mémoire (21), un compteur (22) servant à fournir une valeur de comptage qui indique une adresse d'écriture de la mémoire et un opérateur (23) servant à soustraire effectivement une valeur constante, reliée au nombre d'étages de décalage du registre à décalage, de la valeur de comptage du compteur afin d'indiquer une adresse de lecture de la mémoire, caractérisé en ce que le circuit comporte un multiplexeur, disposé du côté d'entrée de l'opérateur, qui est conçu pour recevoir la valeur constante et une adresse de balayage en sortie, et qui a pour fonction de délivrer ladite valeur constante ou bien l'adresse de balayage en sortie à l'opérateur, en fonction d'un signal de validation de balayage délivré au multiplexeur, l'adresse de balayage en sortie étant délivrée à l'opérateur afin de déterminer l'état d'un étage du registre à décalage lors d'une opération de balayage en sortie.

2. Circuit de balayage en sortie selon la revendication 1, en combinaison avec le registre à décalage, où l'opérateur est un soustracteur servant à soustraire la valeur constante la valeur de comptage du compteur.

3. Circuit de balayage en sortie selon la revendication 1, en combinaison avec le registre à décalage, où l'opérateur est un additionneur servant à additionner un complément de la valeur constante à la valeur de comptage du compteur.

FIG. 1

SCAN ADDRESS REGISTER

2

LOW-ORDER ADDRESS

HIGH - ORDER ADDRESS

1-0

LOGICAL BLOCK 0

3-0  3-1  3-2  3-3  3-4  3-5

FLIPFLOP  FLIPFLOP  FLIPFLOP  FLIPFLOP  FLIPFLOP  FLIPFLOP

4-A

MULTIPLEXER

LOGICAL BLOCK 1

1-1

LOGICAL BLOCK 2

1-2

4-B

MULTIPLEXER

0 081 966

## FIG. 2

WRITE DATA

SCAN ENABLE

ADDRESS

SCAN ADDRESS x

MULTI-PLEXER (9)

READ ADDRESS REGISTER (6)

REGISTER FILE (MEMORY) (5)

WRITE ADDRESS REGISTER (7)

ADDRESS

SCAN ADDRESS y

MULTIPLEXER (10)

READ OUT REGISTER (8)

FIG. 3

# FIG. 4

SCAN
ADDRESS

FLIPFLOP
J-5 STAGE                18-0

FLIPFLOP
J-4 STAGE               18-1

FLIPFLOP
J-3 STAGE               18-2

FLIPFLOP
J-2 STAGE               18-3

FLIPFLOP
J-1 STAGE               18-4

MULTIPLEXER

FLIPFLOP
J STAGE                 18-5

19

SCAN OUT PUT

# FIG. 5

INCREMENT

RESET

COUNTER 22

WRITE ADDRESS

FROM PRECEDING STAGES

26 REGISTER
J - k STAGE

21 REGISTER FILE
J - k +I STAGE
⋮
J STAGES

SCAN ENABLE

NUMBER OF SHIFT STAGES k

SCAN ADDRESS x

MULTIPLEXER 24

SUBTRACTOR 23

READ ADDRESS

READ OUT DATA

27 REGISTER
J +I STAGE

MULTIPLEXER 25

REGISTER
J+2 STAGE

SCAN ADDRESS y

SCAN OUT PUT

TO FOLLOWING STAGE

0 081 966